# EUROPEAN PATENT APPLICATION

(11) **EP 4 780 154 A1**
(43) Date of publication of application: **22.07.2026**
(21) Application number: 25215265.7
(22) Date of filing: 12.11.2025
(51) Int. Cl.: H05K 7/20

(54) **UNINTERRUPTIBLE POWER SUPPLY**

(30) Priority: 21.01.2025 CN 202510089083
(71) Applicant: Vertiv Corporation, Westerville, OH 43082 (US)
(72) Inventor: JI, Deming, Xi an, 710005 (CN); HU, Dawei, Xi an, 710005 (CN); YAO, Zhihong, Xi an, 710005 (CN); SUN, Ning, Xi an, 710005 (CN); BAI, Chengkun, Xi an, 710005 (CN)
(74) Representative: Cousens, Nico

(57) **Abstract**

The present disclosure relates to the field of power supply and an uninterruptible power supply is disclosed. The uninterruptible power supply includes a first power board, a liquid cooling plate, a second power board, a first set of power devices arranged on the first power board, and a second set of power devices arranged on the second power board; the liquid cooling plate is stacked between the first power board and the second power board, and is configured to dissipate heat from the first set of power devices and the second set of power devices; the liquid cooling plate comprises an inlet, an outlet, and a cooling passage communicating the inlet and the outlet, and the cooling passage is configured to accommodate a coolant; and the first set of power devices and/or the second set of power devices includes a temperature-sensitive component and multiple power components, and the multiple power components are located in front of the temperature-sensitive component along a flow direction of the coolant in the cooling passage. In the present disclosure, heat dissipation for the temperature-sensitive component with higher temperature sensitivity is prioritized to ensure a service life of the uninterruptible power supply, and then heat dissipation of other power components is performed, so that liquid cooling for all power components is suitably considered.

## Description

The present application claims priority to Chinese Patent Application No. 202510089083.4, titled "UNINTERRUPTIBLE POWER SUPPLY", filed on January 21, 2025 with the China National Intellectual Property Administration.

### FIELD

The present disclosure relates to the technical field of power supply, and in particular, to an uninterruptible power supply.

### BACKGROUND

An uninterruptible Power Supply (UPS) module is key infrastructure that provides continuous power supply to critical equipment. The UPS module ensures that a load can operate normally when a power grid fails or power fluctuates. The UPS module is widely used in data centers, hospitals, financial institutions and other places that require high power stability. A design for a power layout of the UPS module directly affects the performance, efficiency and reliability thereof. The power layout refers to how to reasonably arrange and configure locations and connections of power processing components inside the UPS module. A good power layout design can improve an efficiency, heat dissipation performance and overall reliability of a system.

Conventionally, the UPS module mainly employs air cooling, and the layout of power components is designed based on air duct for the air cooling. However, with the application of liquid cooling, how to reasonably arrange heat-generating components to ensure effective heat dissipation, avoid local overheating, and extend the life of components is a technical problem to be urgently solved for those skilled in the art.

### SUMMARY

The present disclosure discloses an uninterruptible power supply, in which liquid cooling for all power components is achieved.

Technical solutions provided in the present disclosure for achieving the above objective are described below.

An uninterruptible power supply is provided. The uninterruptible power supply includes a first power board, a liquid cooling plate, a second power board, a first set of power devices arranged on the first power board, and a second set of power devices arranged on the second power board;
the liquid cooling plate is stacked between the first power board and the second power board, and is configured to dissipate heat from the first set of power devices and the second set of power devices; the liquid cooling plate includes an inlet, an outlet, and a cooling passage communicating the inlet and the outlet, and the cooling passage is configured to accommodate a coolant; and
the first set of power devices and/or the second set of power devices includes a temperature-sensitive component and multiple power components, and the multiple power components are located along a flow direction of the coolant in the cooling passage. Optionally, the plurality of power components are located in front of and/or adjacent to the temperature-sensitive component.

In the embodiment of the present disclosure, the uninterruptible power supply includes two power boards, namely the first power board and the second power board. Power components are arranged on the power boards to realize operation of the uninterruptible power supply. Heat dissipation of the two power boards is implemented through liquid cooling, that is, the liquid cooling plate is located between the first power board and the second power board, and is configured to dissipate heat from all the power components on the first power board and/or the second power board. The liquid cooling plate includes the inlet, the outlet and the cooling passage. The coolant enters the cooling passage from the inlet and finally flows out of the liquid cooling plate from the outlet. In arrangement of the components on the power boards, the temperature-sensitive component with higher temperature sensitivity is liquid-cooled first, and then other power components are liquid-cooled. Therefore, with arrangement of the power components of the uninterruptible power supply in the embodiment of the present disclosure, according to design of the cooling passage, heat dissipation for the temperature-sensitive component with higher temperature sensitivity is prioritized to ensure a service life of the uninterruptible power supply, and then heat dissipation of other power components is performed, so that liquid cooling for all power components is suitably considered.

In some embodiments, the inlet and the outlet are located on the same side of the liquid cooling plate;
the cooling passage includes a liquid inlet passage, a liquid outlet passage, and multiple curved passages connected between the liquid inlet passage and the liquid outlet passage; and
the liquid inlet passage extends along a first direction, and the multiple curved passages include a first curved passage which is immediately adjacent to the liquid inlet passage; the orthographic projection of the temperature-sensitive component on the liquid cooling plate is overlapped with the orthographic projection of the first curved passage on the liquid cooling plate.

In some embodiments, the liquid outlet passage extends along the first direction, and the liquid inlet passage and the liquid outlet passage are arranged on both sides of the multiple curved passages along a second direction, respectively; and the multiple curved passages are arranged along the first direction, where the second direction is perpendicular to the first direction.

In some embodiments, the multiple power components include a first power component and a second power component; and
the first power component, the second power component and the temperature-sensitive component are arranged along the first direction; and the orthographic projection of the temperature-sensitive component on the liquid cooling plate covers the orthographic projection of the first curved passage on the liquid cooling plate.

In some embodiments, the multiple power components include a first power component and a second power component; and
the first power component and the second power component are arranged along the first direction; the temperature-sensitive component is arranged along the second direction with respect to the first power component and the second power component; and the orthographic projection of the temperature-sensitive component on the liquid cooling plate is overlapped with the orthographic projection of the liquid inlet passage on the liquid cooling plate.

In some embodiments, the liquid outlet passage extends along the first direction, and the multiple curved passages are located along the second direction between the liquid inlet passage and the liquid outlet passage; the multiple curved passages further include multiple second curved passages and at least one third curved passage, and the first curved passage and the multiple second curved passages are arranged along the second direction; and the at least one third curved passage is arranged along the first direction with respect to the multiple second curved passages, where the second direction is perpendicular to the first direction.

In some embodiments, the multiple power components include a first power component and a second power component; and
the temperature-sensitive component and the first power component are arranged along the first direction, and the second power component is along the first direction with respect to the first power component; and the orthographic projection of the temperature-sensitive component on the liquid cooling plate is overlapped with the orthographic projection of the liquid inlet passage on the liquid cooling plate.

In some embodiments, a power of the first power component is less than a power of the second power component; and
in the first direction, the temperature-sensitive component and the second power component are located on both sides of the first power component, respectively.

In some embodiments, a power of the second power component is less than a power of the first power component; and
in the first direction, the temperature-sensitive component and the first power component are located on both sides of the second power component, respectively.

In some embodiments, the multiple power components further include a third power component; and
the third power component is located on a side of the temperature-sensitive component close to the inlet or the outlet.

### BRIEF DESCRIPTION OF THE DRAWINGS

FIG. 1 is a schematic diagram of a stacked structure of an uninterruptible power supply according to an embodiment of the present disclosure;
FIG. 2 is a first schematic structural diagram of a liquid cooling plate in an uninterruptible power supply according to an embodiment of the present disclosure;
FIG. 3 is a first schematic diagram of a layout of components on a first power board in an uninterruptible power supply according to an embodiment of the present disclosure;
FIG. 4 is a first schematic diagram of a layout of components on a second power board in an uninterruptible power supply according to an embodiment of the present disclosure;
FIG. 5 is a second schematic diagram of a layout of components on a first power board in an uninterruptible power supply according to an embodiment of the present disclosure;
FIG. 6 is a second schematic diagram of a layout of components on a second power board in an uninterruptible power supply according to an embodiment of the present disclosure;
FIG. 7 is a second schematic structural diagram of a liquid cooling plate in an uninterruptible power supply according to an embodiment of the present disclosure;
FIG. 8 is a third schematic diagram of a layout of components on a first power board in an uninterruptible power supply according to an embodiment of the present disclosure;
FIG. 9 is a third schematic diagram of a layout of components on a second power board in an uninterruptible power supply according to an embodiment of the present disclosure;
FIG. 10 is a fourth schematic diagram of a layout of components on a first power board in an uninterruptible power supply according to an embodiment of the present disclosure; and
FIG. 11 is a fourth schematic diagram of a layout of components on a second power board in an uninterruptible power supply according to an embodiment of the present disclosure.

Reference signs in the drawings are listed below.
M1-First power board; M2-Second power board; A-Cold plate coverage area;
1-Housing; 11-Reinforcement rib board; 2-Control board; 3-Liquid cooling plate;
4-Temperature-sensitive component; 5-First power component; 6-Second power component;
7-Third power component; 31-Inlet; 32-Outlet; 33-Cooling passage;
331- Liquid inlet passage; 332- Liquid outlet passage; 333-Curved passage;
333a-First Curved passage; 333b-Second Curved passage; 333c-Third curved passage.

### DETAILED DESCRIPTION

Hereinafter technical solutions of embodiments of the present disclosure are described clearly and completely in conjunction with the drawings for the embodiments of the present disclosure. Apparently, the embodiments described below are only some embodiments, rather than all the embodiments of the present disclosure. Any other embodiments obtained by those skilled in the art based on the embodiments in the present disclosure without any creative effort shall fall within the protection scope of the present disclosure. In the description of the embodiments of the present disclosure, unless otherwise stated, "/" means OR, for example, A/B refers to A or B. In addition, "and/or" is merely an association relationship describing associated objects and may contain three relationships. For example, A and/or B may indicate only A, both A and B, or only B. In addition, in the description for the embodiment of the present disclosure, "plurality/multiple" means two or more.

In the following description, terms "first", "second", and the like, are for descriptive purposes only and cannot be understood as indicating or implying relative importance or implicitly indicating quantities of indicated technical features. Therefore, a feature defined with "first" or "second" may explicitly or implicitly include one or more such feature. In the description of the embodiments of the present disclosure, unless otherwise specified, "plurality/multiple" means two or above two.

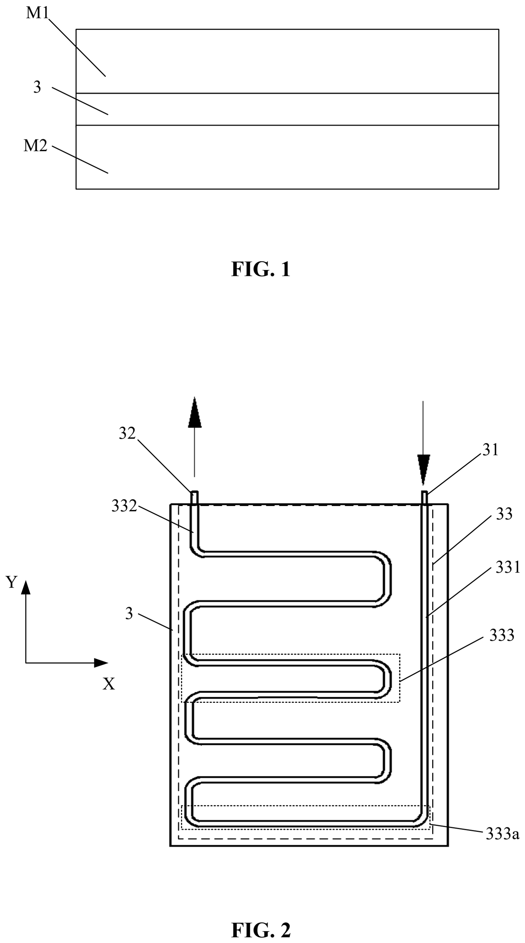

As shown in FIGs. 1 to 4, an embodiment of the present disclosure provides an uninterruptible power supply. The uninterruptible power supply includes a first power board M1, a liquid cooling plate 3, a second power board M2, a first set of power devices arranged on the first power board M1, and a second set of power devices arranged on the second power board M2.

The liquid cooling plate 3 is stacked between the first power board M1 and the second power board M2, and is configured to dissipate heat from the first set of power devices and the second set of power devices. The liquid cooling plate 3 includes an inlet 31, an outlet 32, and a cooling passage 33 communicating the inlet 31 and the outlet 32. The cooling passage 33 is configured to accommodate a coolant.

The first set of power devices and/or the second set of power devices include a temperature-sensitive component 4 and multiple power components. The multiple power components are located in front of the temperature-sensitive component 4 along a flow direction of the coolant in the cooling passage 33.

The uninterruptible power supply provided by the embodiment of the present disclosure includes two power boards, that is, the first power board M1 and the second power board M2. Power components are arranged on the power boards to realize operation of the uninterruptible power supply. Heat dissipation of the two power boards is implemented through liquid cooling, that is, the liquid cooling plate 3 is located between the first power board M1 and the second power board M2, and is configured to dissipate heat from all the power components on the first power board M1 and/or the second power board M2. That is, the liquid cooling plate 3 performs heat dissipation on both sides thereof. The liquid cooling plate 3 includes the inlet 31, the outlet 32 and the cooling passage 33. A coolant enters the cooling passage 33 from the inlet 31 and finally discharges from the liquid cooling plate 3 through the outlet 32. In the arrangement of the components on the power boards, the temperature-sensitive component 4 with higher temperature sensitivity is liquid-cooled first, and then other power components are liquid-cooled. Therefore, in the arrangement of the power components of the uninterruptible power supply in the embodiment of the present disclosure, according to design of the cooling passage 33, heat dissipation for the temperature-sensitive component 4 with higher temperature sensitivity is prioritized to ensure a service life of the uninterruptible power supply, and then heat from other power components is dissipated, so that liquid cooling for all power components is also achieved.

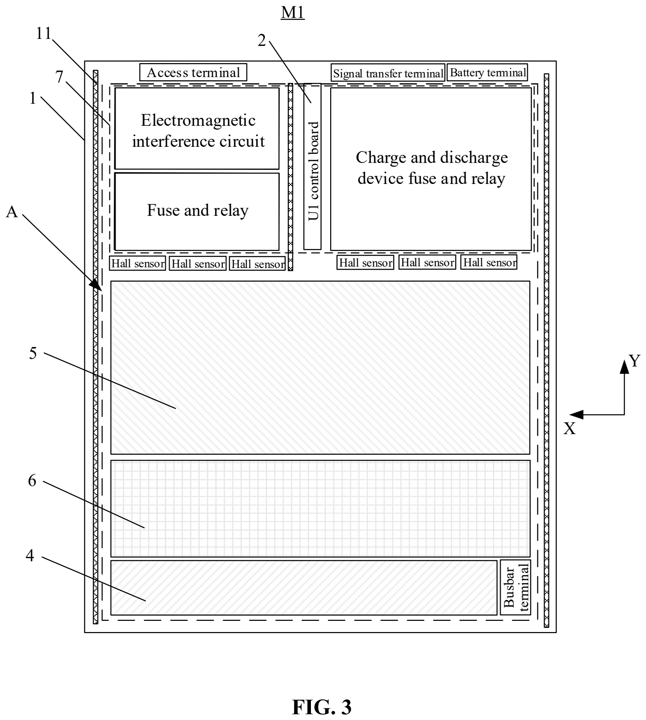

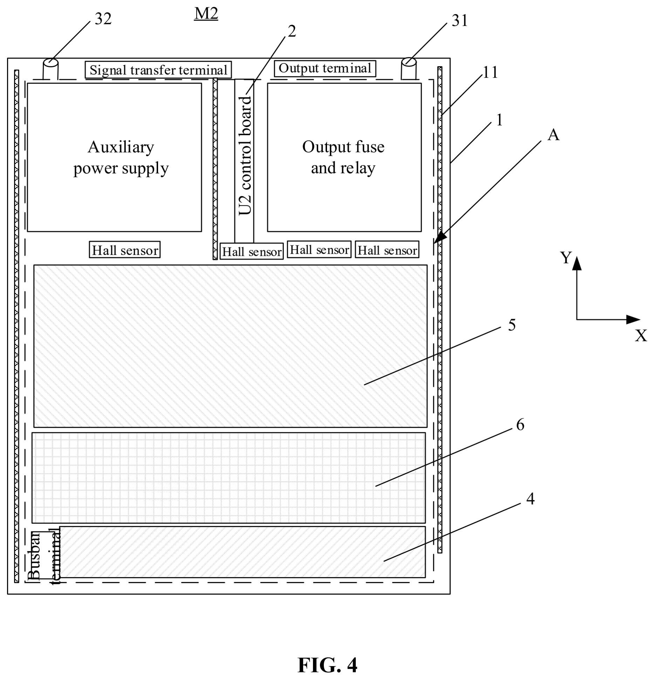

In an embodiment, as shown in FIG. 1, the uninterruptible power supply includes a first power board M1 and a second power board M2 that are buckled together and a liquid cooling plate 3 located between the first power board M1 and the second power board M2. As shown in FIG. 3 and FIG. 4, each of the first power board M1 and the second power board M2 includes a housing 1, and two housings 1 of the first power board M1 and the second power board M2 are buckled together to form an outer shell of the uninterruptible power supply. In order to ensure strength of the housing 1, multiple reinforcement ribs 11 are formed on the housing 1. A control board 2 is further disposed on the housing 1. An orthographic projection of the liquid cooling plate 3 on the first power board M1, that is, a cold plate coverage area A, is as shown in FIG. 3 and FIG. 4. Multiple power components are arranged on each of the first power board M1 and the second power board M2. The cold plate coverage area A covers the area where the multiple power components are arranged, so as to ensure that the liquid cooling plate 3 performs liquid cooling for all the power components. A service life of the temperature-sensitive component 4 is inversely proportional to a raised temperature, and therefore heat dissipation of the temperature-sensitive component needs to be prioritized. In an embodiment, the temperature-sensitive component 4 is a busbar electrolytic capacitor.

It can be understood that, in the uninterruptible power supply provided by the embodiment of the present disclosure, the power components are arranged according to a power flow direction of the power components and in conjunction with the terms of the liquid cooling. In an embodiment of the present disclosure, the power components of the uninterruptible power supply are arranged along a flow direction of the cooling passage 33, and heat dissipation of the temperature-sensitive component 4 is prioritized.

In some embodiments, as shown in FIG. 2, the inlet 31 and the outlet 32 are located on the same side of the liquid cooling plate 3.

The cooling passage 33 includes a liquid inlet passage 331, a liquid outlet passage 332, and multiple curved passages 333 connected between the liquid inlet passage 331 and the liquid outlet passage 332.

The liquid inlet passage 331 extends along a first direction (Y direction in FIG. 2), and the multiple curved passages 333 include a first curved passage 333a which is immediately adjacent to the liquid inlet passage 331. The orthographic projection of the temperature-sensitive component 4 on the liquid cooling plate 3 is overlapped with the orthographic projection of the first curved passage 333a on the liquid cooling plate 3.

In an embodiment, as shown in FIG. 2, an overall shape of the cold plate is a flat cuboid, with a rectangular surface serving as a heat dissipation surface, and the inlet 31 and the outlet 32 are located on the same side of the rectangular surface. The cooling passage 33 communicating with the inlet 31 and the outlet 32 is arranged along the rectangular surface. The cooling passage 33 includes a liquid inlet passage 331, a liquid outlet passage 332 and multiple curved passages 333. The liquid inlet passage 331 is a straight passage and extends along a first direction, i.e., the Y direction in FIG. 2. The multiple curved passages 333 can reduce a flow velocity of the coolant and prolong the time of the coolant remains in the passages, and thereby improve heat dissipation efficiency. The curved passage 333 directly connected to the liquid inlet passage 331 among the multiple curved passages 333 is defined as a first curved passage 333a. In a case where the temperature-sensitive component 4 is arranged on the first power board M1 and the second power board M2, the orthographic projection of the temperature-sensitive component 4 on the liquid cooling plate 3 is overlapped with the orthographic projection of the first curved passage 333a on the liquid cooling plate 3, so that heat from the temperature-sensitive component 4 is preferentially dissipated by a coolant with a low temperature entering from the liquid inlet passage 331. In this way, the service life of the temperature-sensitive component 4 is improved.

In some embodiments, as shown in FIG. 2, the liquid outlet passage 332 extends along the first direction, and the liquid inlet passage 331 and the liquid outlet passage 332 are arranged on both sides of the multiple curved passages 333 along a second direction, respectively. The multiple curved passages 333 are arranged along the first direction. The second direction is perpendicular to the first direction. The first direction refers to the Y direction in FIG. 2, and the second direction refers to the X direction in FIG. 2.

In an embodiment, as shown in FIG. 2, in the cooling passage 33, the liquid inlet passage 331 and the liquid outlet passage 332 both extend along a long side of the liquid cooling plate 3. Each curved passage 333 of the multiple curved passages 333 extends along a short side of the liquid cooling plate 3, and the multiple curved passages 333 are arranged along the long side of the liquid cooling plate 3.

In some embodiments, the curved passage 333 has at least one curved portion. With the curved portion, a flow velocity of the coolant is reduced, and thereby the time of the coolant remaining at the curved portion is prolonged and heat dissipation efficiency is improved. In an embodiment, the curved passage 333 is L-shaped. In another embodiment, the curved passage 333 is U-shaped. In another embodiment, the curved passage 333 is N-shaped. In another embodiment, the curved passage 333 is M-shaped.

It should be noted that, the multiple curved passages 333 may be the same as or different from each other in terms of shape and/or size.

In some embodiments, the multiple power components include a first power component 5 and a second power component 6.

The first power component 5, the second power component 6 and the temperature-sensitive component 4 are arranged along the first direction. The orthographic projection of the temperature-sensitive component 4 on the liquid cooling plate 3 covers the orthographic projection of the first curved passage 333a on the liquid cooling plate 3.

In some embodiments, as shown in FIG. 3, an arrangement surface of the first power board M1 on which the power components to be arranged has a rectangular shape, and the temperature-sensitive component 4, the first power component 5 and the second power component 6 are arranged on the first power board M1. Referring to FIG. 2, the liquid inlet passage 331 extends from an upper short side to near a bottom short side along a long side of the liquid cooling plate 3. The temperature-sensitive component 4 is arranged close to the bottom short side of the first power board M1 and covers a corresponding area of the first curved passage 333a in the cold plate coverage area A. It is defined that the temperature-sensitive component 4 in FIG. 3 is placed horizontally. Along the Y direction in FIG. 3, the second power component 6 is located between the first power component 5 and the temperature-sensitive component 4. Heat dissipation of components on the first power board M1 is performed in an order of: the temperature-sensitive component 4, the second power component 6, and the first power component 5.

In an embodiment, the temperature-sensitive component 4 is a busbar electrolytic capacitor, the first power component 5 is a power inductor, and the second power component 6 is a power switching device and heat sink. Heat dissipation of components on the first power board M1 is performed in an order of: the busbar electrolytic capacitor, the power switching device and heat sink, and the power inductor.

In some embodiments, as shown in FIG. 4, an arrangement surface of the second power board M2 on which the power components to be arranged has a rectangular shape, and the temperature-sensitive component 4, the first power component 5 and the second power component 6 are arranged on the second power board M2. Referring to FIG. 2, the liquid inlet passage 331 extends from an upper short side to near a bottom short side along a long side of the liquid cooling plate 3. The temperature-sensitive component 4 is arranged close to the bottom short side of the first power board M1 and covers a corresponding area of the first curved passage 333a in the cold plate coverage area A. It is defined that the temperature-sensitive component 4 in FIG. 4 is placed horizontally. Along the Y direction in FIG. 4, the second power component 6 is located between the first power component 5 and the temperature-sensitive component 4. Heat dissipation of components on the second power board M2 is performed in an order of: the temperature-sensitive component 4, the second power component 6, and the first power component 5.

In an embodiment, the temperature-sensitive component 4 is a busbar electrolytic capacitor, the first power component 5 is a power inductor, and the second power component 6 is a power switching device and heat sink. Heat dissipation of components on the second power board M2 is performed in an order of: the busbar electrolytic capacitor, the power switching device and heat sink, and the power inductor.

It can be understood that, referring to FIG. 3 and FIG. 4, the first power board M1 and the second power board M2 are flipped with the Y direction as the flipping axis and buckled together, and then a "sandwich" structure with the liquid cooling plate 3 between the first power board M1 and the second power board M2 is formed.

In some embodiments, the multiple power components include a first power component 5 and a second power component 6.

The first power component 5 and the second power component 6 are arranged along the first direction. The temperature-sensitive component 4 is arranged along the second direction with respect to the first power component 5 and the second power component 6. The orthographic projection of the temperature-sensitive component 4 on the liquid cooling plate 3 is overlapped with the orthographic projection of the liquid inlet passage 331 on the liquid cooling plate 3.

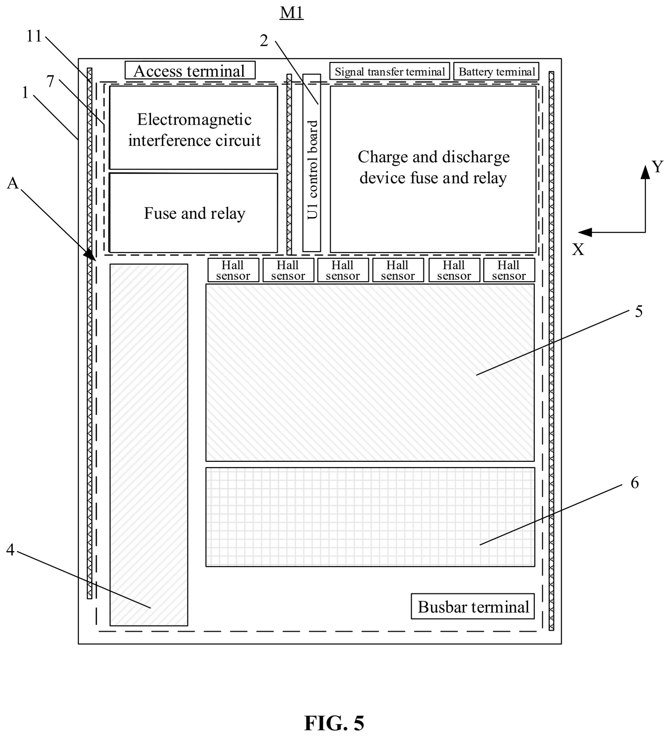

In some embodiments, as shown in FIG. 5, an arrangement surface of the first power board M1 on which the power components to be arranged has a rectangular shape, and the temperature-sensitive component 4, the first power component 5 and the second power component 6 are arranged on the first power board M1. Referring to FIG. 2, the liquid inlet passage 331 extends from an upper short side to near a bottom short side along a long side of the liquid cooling plate 3. The temperature-sensitive component 4 is arranged close to the bottom short side of the first power board M1, and overlaps the first curved passage 333a and a corresponding area in the cold plate coverage area A where the first curved passage 333a communicates with the liquid inlet passage 331. Different from the orientation shown in FIG. 3, the temperature-sensitive component 4 in FIG. 5 is defined to be placed vertically. Along the Y direction in FIG. 5, the first power component 5 is located above the second power component 6, and the temperature-sensitive component 4 is located on the left side of the first power component 5 and the second power component 6. Heat dissipation of components on the first power board M1 is performed in an order of: the temperature-sensitive component 4, the second power component 6, and the first power component 5.

In an embodiment, the temperature-sensitive component 4 is a busbar electrolytic capacitor, the first power component 5 is a power inductor, and the second power component 6 is a power switching device and heat sink. Heat dissipation of components on the first power board M1 is performed in an order of: the busbar electrolytic capacitor, the power switching device and heat sink, and the power inductor.

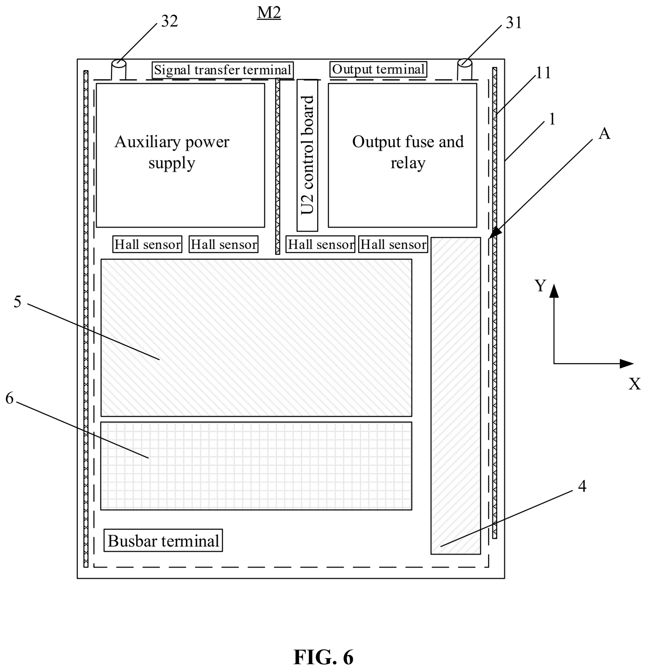

In some embodiments, as shown in FIG. 6, an arrangement surface of the second power board M2 on which the power components to be arranged, and the temperature-sensitive component 4, the first power component 5 and the second power component 6 are arranged on the second power board M2. Referring to FIG. 2, the liquid inlet passage 331 extends from an upper short side to near a bottom short side along a long side of the liquid cooling plate 3. The temperature-sensitive component 4 is arranged close to the bottom short side of the first power board M1, and overlaps the first curved passage 333a and a corresponding area in the cold plate coverage area A where the first curved passage 333a communicates with the liquid inlet passage 331. Different from the orientation shown in FIG. 4, the temperature-sensitive component 4 in FIG. 6 is defined to be placed vertically. Along the Y direction in FIG. 6, the first power component 5 is located above the second power component 6, and the temperature-sensitive component 4 is located on the right side of the first power component 5 and the second power component 6. Heat dissipation of components on the second power board M2 is performed in an order of: the temperature-sensitive component 4, the second power component 6, and the first power component 5.

In an embodiment, the temperature-sensitive component 4 is a busbar electrolytic capacitor, the first power component 5 is a power inductor, and the second power component 6 is a power switching device and heat sink. Heat dissipation of components on the second power board M2 is performed in an order of: the busbar electrolytic capacitor, the power switching device and heat sink, and the power inductor.

It can be understood that, referring to FIG. 5 and FIG. 6, the first power board M1 and the second power board M2 are flipped with the Y direction as the flipping and buckled together, and then a "sandwich" structure with the liquid cooling plate 3 the first power board M1 and the second power board M2 is formed.

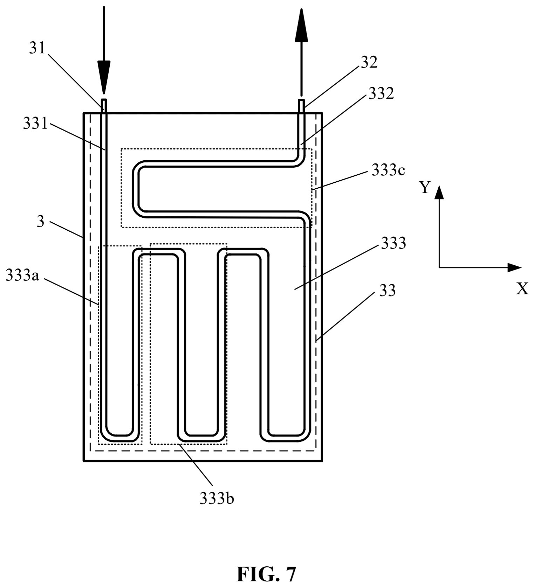

In some embodiments, as shown in FIG. 7, the liquid outlet passage 332 extends along the first direction, and the multiple curved passages 333 are located between the liquid inlet passage 331 and the liquid outlet passage 332 along the second direction; the multiple curved passages 333 further include multiple second curved passages 333b and at least one third curved passage 333c, and the first curved passage 333a and the multiple second curved passages 333b are arranged along the second direction; and the at least one third curved passage 333c is arranged along the first direction with respect to the multiple second curved passages 333b, where the second direction is perpendicular to the first direction. The first direction refers to the Y direction in FIG. 7, and the second direction refers to the X direction in FIG. 7.

In an embodiment, as shown in FIG. 7, in the cooling passage 33, the liquid inlet passage 331 and the liquid outlet passage 332 both extend along a long side of the liquid cooling plate 3. The multiple curved passages 333 include multiple second curved passages 333b and at least one third curved passage 333c. Each of the second curved passages 333b extends along the long side of the liquid cooling plate 3, and the multiple second curved passages 333b are arranged along the short side of the liquid cooling plate 3. The third curved passage 333c extends along the short side of the liquid cooling plate 3. In a case where a number of the third curved passage 333c is more than one, the multiple third curved passages 333c are arranged along the long side of the liquid cooling plate 3.

In some embodiments, the multiple power components include a first power component 5 and a second power component 6.

The temperature-sensitive component 4 and the first power component 5 are arranged along the first direction. The second power component 6 is arranged along the first direction with respect to the first power component 5. The orthographic projection of the temperature-sensitive component 4 on the liquid cooling plate 3 is overlapped with the orthographic projection of the liquid inlet passage 331 on the liquid cooling plate 3.

In some embodiments, a power of the first power component 5 is less than a power of the second power component 6.

In the first direction, the temperature-sensitive component 4 and the second power component 6 are located on both sides of the first power component 5, respectively.

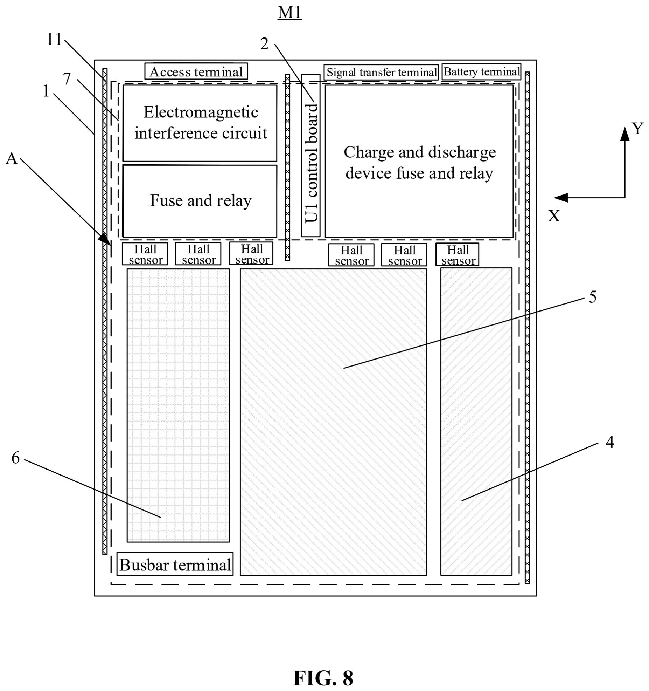

In some embodiments, as shown in FIG. 8, an arrangement surface of the first power board M1 on which the power components to be arranged has a rectangular shape, and the temperature-sensitive component 4, the first power component 5 and the second power component 6 are arranged on the first power board M1. Referring to FIG. 7, the liquid inlet passage 331 extends from an upper short side toward a bottom short side along a long side of the liquid cooling plate 3, and the first curved passage 333a extends along the long side of the liquid cooling plate 3. The temperature-sensitive component 4 is arranged close to the bottom short side of the first power board M1 and covers a corresponding area of the first curved passage 333a in the cold plate coverage area A. It is defined that the temperature-sensitive component 4 in FIG. 8 is placed vertically. Since the power of the first power component 5 is less than the power of the second power component 6, along the X direction in FIG. 8, the first power component 5 is located between the second power component 6 and the temperature-sensitive component 4. Heat dissipation of components on the first power board M1 is performed in an order of: the temperature-sensitive component 4, the first power component 5, and the second power component 6.

In an embodiment, the temperature-sensitive component 4 is a busbar electrolytic capacitor, the first power component 5 is a power inductor, and the second power component 6 is a power switching device and heat sink. Heat dissipation of components on the first power board M1 is performed in an order of: the busbar electrolytic capacitor, the power inductor, and the power switching device and heat sink.

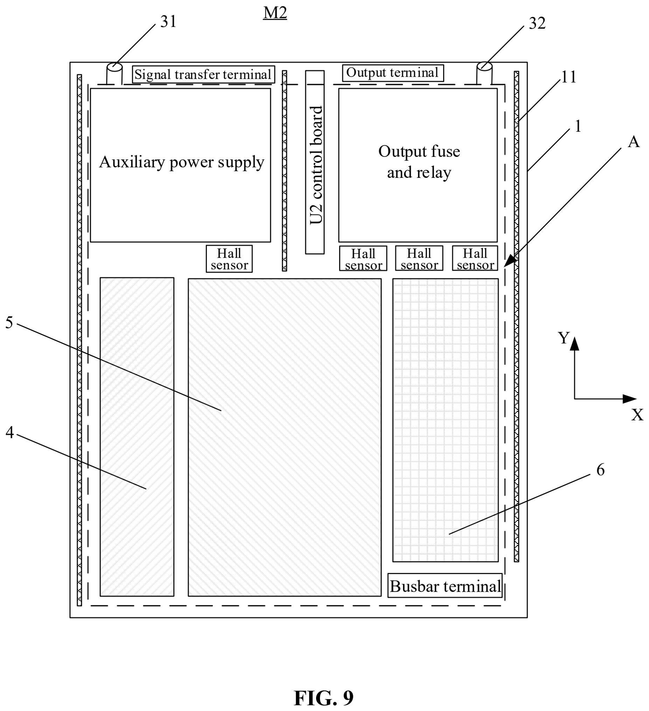

In some embodiments, as shown in FIG. 9, an arrangement surface of second power board M2 on which the power components to be arranged has a rectangular shape, and the temperature-sensitive component 4, the first power component 5 and the second power component 6 are arranged on the second power board M2. Referring to FIG. 7, the liquid inlet passage 331 extends from an upper short side toward a bottom short side along a long side of the liquid cooling plate 3, and the first curved passage 333a extends along the long side of the liquid cooling plate 3. The temperature-sensitive component 4 is arranged close to the bottom short side of the first power board M1 and covers a corresponding area of the first curved passage 333a in the cold plate coverage area A. It is defined that the temperature-sensitive component 4 in FIG. 9 is placed vertically. Since the power of the first power component 5 is less than the power of the second power component 6, along the X direction in FIG. 9, the first power component 5 is located between the second power component 6 and the temperature-sensitive component 4. Heat dissipation of components on the second power board M2 is performed in an order of: the temperature-sensitive component 4, the first power component 5, and the second power component 6.

In an embodiment, the temperature-sensitive component 4 is a busbar electrolytic capacitor, the first power component 5 is a power inductor, and the second power component 6 is a power switching device and heat sink. Heat dissipation of components on the second power board M2 is performed in an order of: the busbar electrolytic capacitor, the power inductor, and the power switching device and heat sink.

It can be understood that, referring to FIG. 8 and FIG. 9, the first power board M1 and the second power board M2 are flipped with the Y direction as the flipping axis and buckled together, and then a "sandwich" structure with the liquid cooling plate 3 between the first power board M1 and the second power board M2 is formed.

In some embodiments, a power of the second power component 6 is less than a power of the first power component 5.

In the first direction, the temperature-sensitive component 4 and the first power component 5 are located on both sides of the second power component 6, respectively.

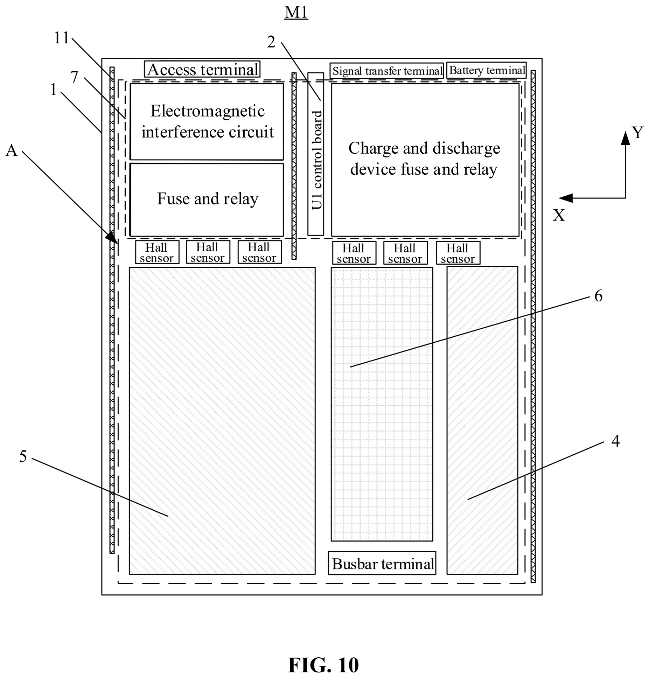

In some embodiments, as shown in FIG. 10, an arrangement surface of the first power board M1 on which the power components to be arranged has a rectangular shape, and the temperature-sensitive component 4, the first power component 5 and the second power component 6 are arranged on the first power board M1. Referring to FIG. 7, the liquid inlet passage 331 extends from an upper short side toward a bottom short side along a long side of the liquid cooling plate 3, and the first curved passage 333a extends along the long side of the liquid cooling plate 3. The temperature-sensitive component 4 is arranged close to the bottom short side of the first power board M1 and covers a corresponding area of the first curved passage 333a in the cold plate coverage area A. It is defined that the temperature-sensitive component 4 in FIG. 10 is placed vertically. Since the power of the second power component 6 is less than the power of the first power component 5, along the X direction in FIG. 10, the second power component 6 is located between the first power component 5 and the temperature-sensitive component 4. Heat dissipation of components on the first power board M1 is performed in an order of: the temperature-sensitive component 4, the second power component 6, and the first power component 5.

In an embodiment, the temperature-sensitive component 4 is a busbar electrolytic capacitor, the first power component 5 is a power inductor, and the second power component 6 is a power switching device and heat sink. Heat dissipation of components on the first power board M1 is performed in an order of: the busbar electrolytic capacitor, the power switching device and heat sink, and the power inductor.

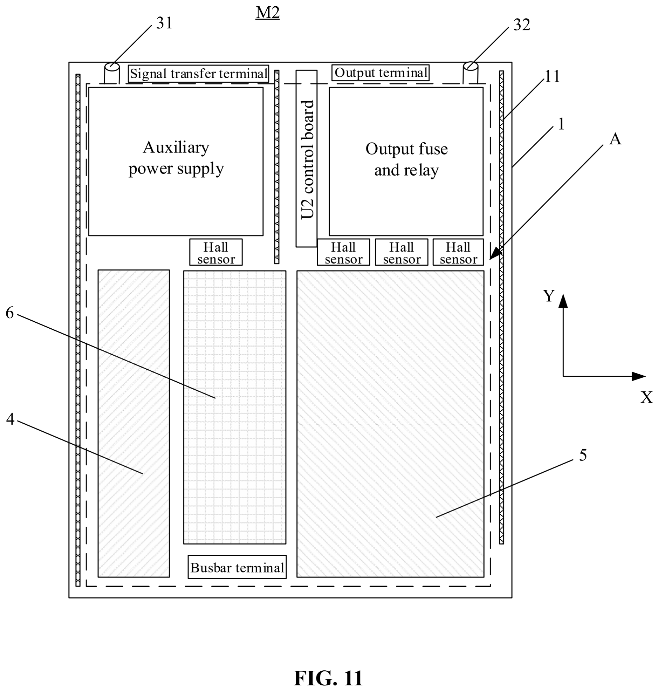

In some embodiments, as shown in FIG. 11, an arrangement surface of the second power board M2 on which the power components to be arranged has a rectangular shape, and the temperature-sensitive component 4, the first power component 5 and the second power component 6 are arranged on the second power board M2. Referring to FIG. 7, the liquid inlet passage 331 extends from an upper short side toward a bottom short side along a long side of the liquid cooling plate 3, and the first curved passage 333a extends along the long side of the liquid cooling plate 3. The temperature-sensitive component 4 is arranged close to the bottom short side of the first power board M1 and covers a corresponding area of the first curved passage 333a in the cold plate coverage area A. It is defined that the temperature-sensitive component 4 in FIG. 11 is placed vertically. Since the power of the second power component 6 is less than the power of the first power component 5, along the X direction in FIG. 11, the second power component 6 is located between the first power component 5 and the temperature-sensitive component 4. Heat dissipation of components on the second power board M2 is performed in an order of: the temperature-sensitive component 4, the second power component 6, and the first power component 5.

In an embodiment, the temperature-sensitive component 4 is a busbar electrolytic capacitor, the first power component 5 is a power inductor, and the second power component 6 is a power switching device and heat sink. Heat dissipation of components on the second power board M2 is performed in an order of: the busbar electrolytic capacitor, the power switching device and heat sink, and the power inductor.

It can be understood that, referring to FIG. 10 and FIG. 11, the first power board M1 and the second power board M2 are flipped with the Y direction as the flipping axis and buckled together, and then a "sandwich" structure with the liquid cooling plate 3 the first power board M1 and the second power board M2 is formed.

In some embodiments, the multiple power components further include a third power component 7; and the third power component 7 is located on a side of the temperature-sensitive component 4 close to the inlet 31 or the outlet 32.

In some embodiments, the third power component 7 on the first power board M1 includes a fuse, a relay, and an electromagnetic interference device. The third power component 7 on the first power board M1 includes a fuse, a relay and an auxiliary power supply.

In an embodiment, as shown in FIG. 3, heat dissipation of components on the first power board M1 is performed in an order of: the inlet 31, the temperature-sensitive component 4, the second power component 6, the first power component 5, the third power component 7, and the outlet 32. As shown in FIG. 4, heat dissipation of components on the second power board M2 is performed in an order of: the inlet 31, the temperature-sensitive component 4, the second power component 6, the first power component 5, the third power component 7, and the outlet 32. In another embodiment, heat dissipation of components on the first power board M1 is performed in an order of: the inlet 31, the busbar electrolytic capacitor, the power switching device and heat sink, the power inductor, the fuse/relay/electromagnetic interference device, and the outlet 32. Heat dissipation of components on the second power board M2 is performed in an order of: the inlet 31, the busbar electrolytic capacitor, the power switching device and heat sink, the power inductor, the fuse/relay/auxiliary power supply, and the outlet 32.

In an embodiment, as shown in FIG. 5, heat dissipation of components on the first power board M1 is performed in an order of: the inlet 31, the temperature-sensitive component 4, the second power component 6, the first power component 5, the third power component 7, and the outlet 32. As shown in FIG. 6, heat dissipation of components on the second power board M2 is performed in an order of: the inlet 31, the temperature-sensitive component 4, the second power component 6, the first power component 5, the third power component 7, and the outlet 32. In another embodiment, heat dissipation of components on the first power board M1 is performed in an order of: the inlet 31, the busbar electrolytic capacitor, the power switching device and heat sink, the power inductor, the fuse/relay/electromagnetic interference device, and the outlet 32. Heat dissipation of components on the second power board M2 is performed in an order of: the inlet 31, the busbar electrolytic capacitor, the power switching device and heat sink, the power inductor, the fuse/relay/auxiliary power supply, and the outlet 32.

In an embodiment, as shown in FIG. 8, heat dissipation of components on the first power board M1 is performed in an order of: the inlet 31, the temperature-sensitive component 4, the first power component 5, the second power component 6, the third power component 7, and the outlet 32. As shown in FIG. 9, heat dissipation of components on the second power board M2 is performed in an order of: the inlet 31, the temperature-sensitive component 4, the first power component 5, the second power component 6, the third power component 7, and the outlet 32. In another embodiment, heat dissipation of components on the first power board M1 is performed in an order of: the inlet 31, the busbar electrolytic capacitor, the power inductor, the power switching device and heat sink, the fuse/relay/electromagnetic interference device, and the outlet 32. Heat dissipation of components on the second power board M2 is performed in an order of: the inlet 31, the busbar electrolytic capacitor, the power inductor, the power switching device and heat sink, the fuse/relay/auxiliary power supply, and the outlet 32.

In an embodiment, as shown in FIG. 10, heat dissipation of components on the first power board M1 is performed in an order of: the inlet 31, the temperature-sensitive component 4, the second power component 6, the first power component 5, the third power component 7, and the outlet 32. As shown in FIG. 11, heat dissipation of components on the second power board M2 is performed in an order of: the inlet 31, the temperature-sensitive component 4, the second power component 6, the first power component 5, the third power component 7, and the outlet 32. In another embodiment, heat dissipation of components on the first power board M1 is performed in an order of: the inlet 31, the busbar electrolytic capacitor, the power switching device and heat sink, the power inductor, the fuse/relay/electromagnetic interference device, and the outlet 32. Heat dissipation of components on the second power board M2 is performed in an order of: the inlet 31, the busbar electrolytic capacitor, the power switching device and heat sink, the power inductor, the fuse/relay/auxiliary power supply, and the outlet 32.

In the uninterruptible power supply provided in the embodiments of the present disclosure, the power switching device and heat sink is decoupled and arranged separately from the bus electrolytic capacitor, giving priority to heat dissipation of the temperature-sensitive component; after passing by the bus electrolytic capacitor, the coolant flows to the power switching device and heat sink with higher heat generation, or the power inductor; finally, heat from components with relatively low heat generation but high temperature derating is dissipated through the passage. Thereby, heat dissipation of all heat-generating components, such as the auxiliary power supply, the electromagnetic interference device, the fuse, the relay, and the Hall sensor, is suitably considered.

Apparently, various modifications and variations to the embodiments of the present disclosure can be made by those skilled in the art without departing from the scope of the present disclosure. Hence, as the modifications and variations of the present disclosure fall within the scope of the claims of the present disclosure, the present disclosure is also intended to include such modifications and variations.

## Claims

1. An uninterruptible power supply comprising:
a first power board (M1);
a liquid cooling plate (3);
a second power board (M2);
a first set of power devices arranged on the first power board; and
a second set of power devices arranged on the second power board,
wherein, the liquid cooling plate is stacked between the first power board and the second power board, and is configured to dissipate heat from the first set of power devices and the second set of power devices; the liquid cooling plate comprises an inlet (31), an outlet (32), and a cooling passage (33) communicating with the inlet and the outlet, and the cooling passage is configured to accommodate coolant; and
wherein, the first set of power devices and/or the second set of power devices comprises a temperature-sensitive component (4) and a plurality of power components, and the plurality of power components are located along a flow direction of the coolant in the cooling passage.

2. The uninterruptible power supply according to claim 1, wherein the inlet and the outlet are located on the same side of the liquid cooling plate;
the cooling passage comprises a liquid inlet passage (331), a liquid outlet passage (332), and a plurality of curved passages (333) connected between the liquid inlet passage and the liquid outlet passage; and
the liquid inlet passage extends along a first direction, and the plurality of curved passages comprise a first curved passage (333a) which is immediately adjacent to the liquid inlet passage; an orthographic projection of the temperature-sensitive component on the liquid cooling plate is overlapped with an orthographic projection of the first curved passage on the liquid cooling plate.

3. The uninterruptible power supply according to claim 1 or 2, wherein the liquid outlet passage extends along the first direction, and the liquid inlet passage and the liquid outlet passage are arranged on both sides of the plurality of curved passages along a second direction, respectively; and the plurality of curved passages are arranged along the first direction, where the second direction is perpendicular to the first direction.

4. The uninterruptible power supply according to any preceding claim, wherein the plurality of power components comprises a first power component (5) and a second power component (6);
the first power component, the second power component and the temperature-sensitive component are arranged along the first direction; and the orthographic projection of the temperature-sensitive component on the liquid cooling plate covers the orthographic projection of the first curved passage on the liquid cooling plate.

5. The uninterruptible power supply according to any preceding claim, wherein the plurality of power components comprise the first power component and the second power component;
the first power component and the second power component are arranged along the first direction; the temperature-sensitive component is arranged along the second direction with respect to the first power component and the second power component; and the orthographic projection of the temperature-sensitive component on the liquid cooling plate is overlapped with the orthographic projection of the liquid inlet passage on the liquid cooling plate.

6. The uninterruptible power supply according to claim 2 or any of claims 3 to 5 when dependent on claim 2, wherein the liquid outlet passage extends along the first direction, and the plurality of curved passages are located between the liquid inlet passage and the liquid outlet passage along a second direction; the plurality of curved passages further comprise a plurality of second curved passages (333b) and at least one third curved passage (333c), and the first curved passage and the plurality of second curved passages are arranged along the second direction; and the at least one third curved passage is arranged along the first direction with respect to the plurality of second curved passages, where the second direction is perpendicular to the first direction.

7. The uninterruptible power supply according to claim 6, wherein the plurality of power components comprise a first power component and a second power component; and
the temperature-sensitive component and the first power component are arranged along the first direction, and the second power component is are arranged along the first direction with respect to the first power component; and the orthographic projection of the temperature-sensitive component on the liquid cooling plate is overlapped with the orthographic projection of the liquid inlet passage on the liquid cooling plate.

8. The uninterruptible power supply according to claim 7, wherein a power of the first power component is less than a power of the second power component; and
in the first direction, the temperature-sensitive component and the second power component are located on both sides of the first power component, respectively.

9. The uninterruptible power supply according to claim 7 or 8, wherein a power of the second power component is less than a power of the first power component; and
in the first direction, the temperature-sensitive component and the first power component are located on both sides of the second power component, respectively.

10. The uninterruptible power supply according to any preceding claim, wherein the plurality of power components further comprise a third power component; and
the third power component is located on a side of the temperature-sensitive component close to the inlet or the outlet.

11. The uninterruptible power supply according to any preceding claim, wherein the plurality of power components are located in front of and/or adjacent to the temperature-sensitive component.
